# FASCICULE DE BREVET EUROPEEN

(11) **EP 1 042 679 B1**
(45) Date de publication et mention de la délivrance du brevet: **05.03.2003**
(21) Numéro de dépôt: 98962513.2
(22) Date de dépôt: 18.12.1998
(51) Int. Cl.: G01R 19/165, G01R 35/00

(54) **CIRCUIT ELECTRONIQUE DE SURVEILLANCE DE TENSION ELECTRIQUE**
ELEKTRONISCHE ÜBERWACHUNGSSCHALTUNG FÜR ELEKTRISCHE SPANNUNG
ELECTRONIC CIRCUIT FOR MONITORING VOLTAGE VARIATION

(30) Priorité: 23.12.1997 FR 9716346
(43) Date de publication de la demande: 11.10.2000
(73) Titulaire: THALES AVIONICS S.A., 78141 Vélizy Villacoublay Cédex (FR)
(72) Inventeur: TAURAND, Christophe, 94117 Arcueil Cedex (FR)
(74) Mandataire: Beylot, Jacques
(86) Numéro de dépôt international: FR9802789
(87) Numéro de publication internationale: WO99034223

(56) Documents cités:
- US-A- 4 743 779
- US-A- 4 977 530
- PATENT ABSTRACTS OF JAPAN vol. 097, no. 012, 25 décembre 1997 & JP 09 218250 A (KAWASAKI STEEL CORP), 19 août 1997

## Description

La présente invention concerne un circuit électronique de surveillance de tension électrique, et plus particulièrement un tel circuit comprenant une borne de seuil haute et une borne de seuil basse, et des moyens pour comparer la tension relevée sur ces bornes à une tension de référence pour déterminer si la tension sur la borne de seuil haute n'est pas supérieure à un seuil prédéterminé et si la tension sur la borne de seuil basse n'est pas inférieure à un, éventuellement autre, seuil prédéterminé.

Le brevet américain US 4,743,779 donne un exemple de circuit électronique de surveillance de tension de la technique antérieure qui est de type comparateur à fenêtre, avec des tensions de seuils haut et bas ajustées simultanément à l'aide d'un unique potentiomètre de manière à conserver fixe la tension médiane au centre de la fenêtre.

La difficulté avec les circuits électroniques de surveillance de tension connus dans la technique antérieure provient de ce qu'il n'est pas possible de savoir, lorsqu'une panne est détectée, si elle est le fait de la tension surveillée, ou du circuit de surveillance lui-même. Le circuit de surveillance peut en effet signaler une panne du fait de sa propre défaillance, alors que la tension surveillée est normale.

Inversement, et c'est le point essentiel, le circuit de surveillance peut être en panne, et dans ce cas omettre de signaler une panne du circuit générant la tension à surveiller. Or, tout particulièrement dans le domaine de l'avionique, si l'on peut parfois tolérer une panne, par exemple parce que l'équipement en panne est doublé ou triplé, on peut très souvent ne pas tolérer de ne pas savoir que cette panne existe.

La présente invention vise à pallier cet inconvénient.

Elle a pour objet un circuit électronique de surveillance de tension électrique, comprenant une borne de seuil haute et une borne de seuil basse, et des moyens pour comparer la tension relevée sur ces bornes à une tension de référence pour déterminer si la tension sur la borne de seuil haute n'est pas supérieure à un premier seuil prédéterminé et si la tension sur la borne de seuil basse n'est pas inférieure à un deuxième seuil prédéterminé pouvant prendre la même valeur que le premier seuil prédéterminé, caractérisé par le fait qu'il comprend des moyens pour forcer la tension sur la borne de seuil haute à une valeur basse inférieure audit premier seuil prédéterminé et/ou à une valeur haute supérieure audit premier seuil prédéterminé, et des moyens pour forcer la tension sur la borne de seuil basse à une valeur haute supérieure audit deuxième seuil prédéterminé et/ou à une valeur basse inférieure audit deuxième seuil prédéterminé.

Avantageusement, le circuit selon l'invention peut comprendre deux comparateurs, l'un des comparateurs étant agencé pour recevoir sur une première de ses entrées formant la borne de seuil haute du circuit, en surveillance de niveau de tension, une tension haute dérivée de la tension à surveiller, et une tension de référence sur son autre entrée, et l'autre comparateur étant agencé pour recevoir sur une première de ses entrées formant la borne de seuil basse du circuit, en surveillance de niveau de tension, une tension basse dérivée de la tension à surveiller, et une, éventuellement autre, tension de référence sur son autre entrée, un premier commutateur étant prévu pour appliquer une tension haute supérieure à ladite tension de référence à l'une ou l'autre de ces entrées, et un deuxième commutateur permettant d'appliquer à l'autre entrée une tension basse inférieure à ladite, éventuellement autre, tension de référence.

On décrira maintenant, à titre d'exemple non limitatif, un mode de réalisation particulier de l'invention, en référence aux dessins schématiques annexés dans lesquels:
- la figure 1 est un schéma électronique illustrant l'utilisation d'un comparateur à fenêtre pour la surveillance d'une tension dans une certaine fenêtre de surveillance,
- la figure 2 est un schéma électronique illustrant l'utilisation de ce comparateur à fenêtre pour la surveillance de deux niveaux booléens; et
- la figure 3 est un schéma d'un circuit électronique de surveillance selon l'invention.

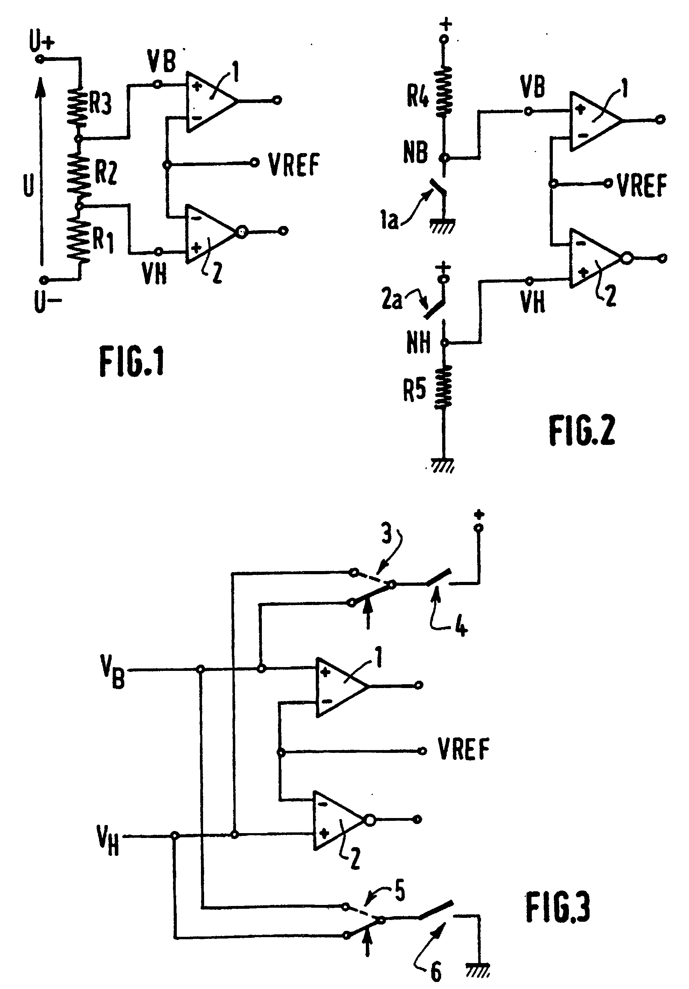

On voit sur la figure 1 un comparateur à fenêtre destiné à la surveillance d'une tension continue U entre U- et U+.

A cet effet, la tension U est divisée par un pont diviseur constitué de trois résistances R1, R2 et R3 en série de U- à U+, de manière à obtenir une tension intermédiaire VH au point commun entre R1 et R2 et une tension intermédiaire VB au point commun entre R2 et R3. Le comparateur a pour fonction de vérifier que la tension VH est inférieure à une tension de référence et que la tension VB est supérieure à, également, une tension de référence. Les tensions de référence sont ici toutes deux égales à VREF.

Le comparateur à fenêtre est formé de deux comparateurs 1 et 2, le comparateur 2 ayant sa sortie inversée. La tension VB est fournie à l'entrée directe du comparateur 1. La tension VH est fournie à l'entrée directe du comparateur 2. La même tension de référence VREF est appliquée aux entrées inversées des deux comparateurs 1 et 2.

On constate par conséquent que la tension de sortie du comparateur 1 viendra à son niveau bas lorsque la tension VB, au point commun à R2 et R3, deviendra inférieure à la tension de référence. De même, la tension de sortie du comparateur inverseur 2 viendra à son niveau bas lorsque la tension VH, au point commun à R1 et R2, deviendra supérieure à la tension de référence.

Dans le mode de réalisation représenté, on détectera donc un état de panne lorsque la sortie d'au moins un des comparateurs 1 et 2 viendra au niveau bas. Bien évidemment, les niveaux pourraient être inversés, et un état de panne détecté lorsque l'une des sorties vient au niveau haut

Bien entendu, les valeurs des résistances R1, R2 et R3 sont choisies en fonction de la tension de référence VREF et des tolérances autorisées sur la tension U.

La figure 2 illustre l'utilisation du même comparateur pour la lecture de deux niveaux booléens.

On voit ici la borne d'entrée VB du comparateur à fenêtre reliée à une des bornes NB d'un interrupteur 1a. De même, la borne d'entrée VH est reliée à une des bornes NH d'un interrupteur 2a. Par ailleurs, la borne NB est également reliée à l'alimentation par l'intermédiaire d'une résistance R4 et la borne NH est également reliée à la masse par l'intermédiaire d'une résistance R5. Enfin, l'autre borne de l'interrupteur 1a est directement reliée à la masse et l'autre borne de l'interrupteur 2a est directement reliée à l'alimentation.

Par hypothèse, le dispositif à surveiller entraîne la fermeture d'un des interrupteurs 1a ou 2a en cas de panne.

On souhaite donc ici détecter si l'un des interrupteurs 1 ou 2a est fermé. On voit en effet que la sortie du comparateur 1 sera au niveau bas si l'interrupteur 1a est fermé, et au niveau haut si l'interrupteur 1a est ouvert. De même, la sortie du comparateur inverseur 2 sera au niveau bas si l'interrupteur 2a est fermé, et au niveau haut si l'interrupteur 2a est ouvert.

Le schéma de la figure 3 est celui du circuit de surveillance complet, avec ses fonctions d'auto-test.

L'entrée VB du comparateur 1 et l'entrée VH du comparateur 2 peuvent maintenant être forcées soit à une tension haute, ici la tension d'alimentation, soit à une tension basse, ici la masse. A cet effet, la tension d'alimentation peut être reliée soit à VB soit à VH selon la position d'un commutateur à deux voies 3. Un interrupteur 4 en série avec le commutateur 3 permet de désactiver ce dernier.

De même, la masse peut être reliée soit à VH soit à VB selon la position d'un commutateur 5 à deux voies, qui peut être désactivé par un interrupteur 6 en série. Les deux commutateurs 3 et 5 sont commandés simultanément, de telle sorte que VH est reliée à la masse lorsque VB est reliée à l'alimentation, et réciproquement, VH est reliée à l'alimentation lorsque VB est reliée à la masse.

En mode normal, les interrupteurs 4 et 6 sont ouverts et le circuit de surveillance fonctionne comme cela a été décrit en référence aux figures 1 et 2, selon qu'il est utilisé à la surveillance de niveaux de tensions ou de niveaux booléens.

En mode d'auto-test, c'est-à-dire lorsque l'on souhaite que le circuit de surveillance détecte son éventuel propre état de panne, les commutateurs 3 et 5 sont commandés en fonction de la nature, niveau de tension ou niveau booléen, des entrées appliquées à VB et VH, et les interrupteurs 4 et 6 sont successivement fermés.

Dans le cas où le circuit est destiné à surveiller des tensions, comme à la figure 1, les commutateurs 3 et 5 sont placés dans leur position représentée en traits pleins à la figure 3.

La borne d'entrée VB est alors tout d'abord reliée à l'alimentation par fermeture de l'interrupteur 4, en vue d'effectuer un test de déclenchement sur la borne VH du comparateur à fenêtre. Le résultat du test est détecté à la sortie du comparateur 2. Si le circuit fonctionne convenablement, la tension à la borne VH sera amenée par la résistance R2 à une valeur supérieure à la tension de référence VREF, et la sortie du comparateur 2 passera au niveau bas.

L'interrupteur 4 est ensuite réouvert et l'interrupteur 6 fermé pour amener la borne VH à la masse. On effectue alors le test de déclenchement sur la borne VB du comparateur à fenêtre, le résultat de ce test étant maintenant détecté à la sortie du comparateur 1. Si le circuit fonctionne convenablement, la tension à la borne VB sera amenée par la résistance R2 à une valeur inférieure à la tension de référence VREF, et la sortie du comparateur 1 passera au niveau bas.

On observera que la détection d'une panne en mode d'auto-test (niveau haut à la sortie d'un des comparateurs 1 et 2) est inversée par rapport au mode de fonctionnement normal.

Dans le cas où le circuit est destiné à lire des niveaux booléens comme à la figure 2, les commutateurs 3 et 4 sont, en mode d'auto-test, placés dans leur position représentée en pointillés à la figure 3.

On teste alors le circuit de détection lié à la borne d'entrée VB en fermant l'interrupteur 6, ce qui amène VB à la masse. Un fonctionnement convenable du circuit amènera donc le potentiel de la borne VB en dessous du potentiel de référence VREF, donc la sortie du comparateur 1 au niveau bas. Ce qui équivaut à la détection d'une panne en mode normal.

On teste ensuite de la même manière le circuit de détection lié à la borne d'entrée VH en réouvrant l'interrupteur 6 et en fermant l'interrupteur 4 pour amener VH à la tension d'alimentation. Si le circuit fonctionne normalement, le potentiel à la borne VH sera ainsi supérieur à la tension VREF et la sortie du comparateur 2 passera au niveau bas.

Ainsi, dans tous les cas, une panne sera détectée en mode d'auto-test, par une inversion du niveau de la sortie d'un des comparateurs 1 et 2 par rapport à une détection de panne en mode normal.

On a décrit en référence à la figure 3 un mode de réalisation utilisant deux interrupteurs 4 et 6 et deux commutateurs 3 et 5. Le même résultat aurait pu être obtenu de façon équivalente à l'aide de quatre interrupteurs.

On pourrait en effet relier l'alimentation aux deux bornes d'entrée VB et VH, chacune par l'intermédiaire d'un interrupteur. De même pour la masse, par l'intermédiaire de deux autres interrupteurs. Les tests s'effectuent alors en fermant dans chaque cas un interrupteur, les trois autres restant ouverts.

Le test croisé qui vient d'être décrit présente comme avantage, en mode de surveillance de tension, de s'assurer de l'intégrité de la résistance R2 et des fils de connexion. Il présente en outre l'avantage de ne nécessiter que deux bornes de connexion et de pouvoir être utilisé indifféremment dans les deux modes de fonctionnement.

## Revendications

1. Circuit électronique de surveillance de tension électrique, comprenant une borne de seuil haute (VH) et une borne de seuil basse (VB), et des moyens pour comparer la tension relevée sur ces bornes à une tension de référence pour déterminer si la tension sur la borne de seuil haute n'est pas supérieure à un premier seuil prédéterminé et si la tension sur la borne de seuil basse n'est pas inférieure à un deuxième seuil prédéterminé pouvant prendre la même valeur que le premier seuil prédéterminé, **caractérisé par le fait qu'**il comprend des moyens (3-6) pour forcer la tension sur la borne de seuil haute à une valeur basse inférieure audit premier seuil prédéterminé et/ou à une valeur haute supérieure audit premier seuil prédéterminé, et des moyens (3-6) pour forcer la tension sur la borne de seuil basse à une valeur haute supérieure audit deuxième seuil prédéterminé et/ou à une valeur basse inférieure audit deuxième seuil prédéterminé.

2. Circuit selon la revendication 1, comprenant deux comparateurs (1,2), l'un des comparateurs (1) étant agencé pour recevoir sur une première de ses entrées formant la borne de seuil haute du circuit, en surveillance de niveau de tension, une tension haute dérivée de la tension à surveiller, et une première tension de référence sur son autre entrée, et l'autre comparateur (2) étant agencé pour recevoir sur une première de ses entrées formant la borne de seuil basse du circuit, en surveillance de niveau de tension, une tension basse dérivée de la tension à surveiller, et, sur son autre entrée, une deuxième tension de référence pouvant prendre la même valeur que la première tension de référence, un premier commutateur (3) étant prévu pour appliquer une tension haute supérieure à ladite première tension de référence à l'une ou l'autre de ces entrées, et un deuxième commutateur (5) permettant d'appliquer à l'autre entrée une tension basse inférieure à ladite deuxième tension de référence.

## Claims

1. Electronic circuit for monitoring electrical voltage, comprising a high threshold terminal (VH) and a low threshold terminal (VB), and means for comparing the voltage sensed on these terminals with a reference voltage so as to determine whether the voltage on the high threshold terminal is not greater than a first predetermined threshold and whether the voltage on the low threshold terminal is not less than a second predetermined threshold capable of taking the same value as the first predetermined threshold, **characterized in that** it comprises means (3-6) for prescribing the voltage on the high threshold terminal at a low value less than the said first predetermined threshold and/or at a high value greater than the said first predetermined threshold, and means (3-6) for prescribing the voltage on the low threshold terminal at a high value greater than the said second predetermined threshold and/or at a low value less than the said second predetermined threshold.

2. Circuit according to Claim 1, comprising two comparators (1, 2), one of the comparators (1) being devised so as to receive on a first of its inputs forming the high threshold terminal of the circuit, during voltage level monitoring, a high voltage derived from the voltage to be monitored, and, on its other input, a second reference voltage capable of taking the same value as the first reference voltage, a first switch (3) being provided so as to apply a high voltage greater than the said first reference voltage to one or the other of these inputs, and a second switch (5) making it possible to apply to the other input a low voltage less than the said second reference voltage.

## Patentansprüche

1. Elektronische Schaltung zur Überwachung einer elektrischen Spannung mit einer Klemme (VH) für einen oberen Schwellwert und einer Klemme (VB) für einen unteren Schwellwert und mit Mitteln zum Vergleich der an diesen Klemmen abgegriffenen Potentiale mit einem Bezugspotential, um zu bestimmen, ob das Potential an der Klemme für den oberen Schwellwert nicht einen vorbestimmten ersten Grenzwert überschreitet und ob das Potential an der Klemme für den unteren Schwellwert nicht einen zweiten vorbestimmten Grenzwert unterschreitet, der den gleichen Wert wie der erste vorbestimmte Grenzwert annehmen kann, **dadurch gekennzeichnet, daß** sie Mittel (3 bis 6), um das Potential an der Klemme für den oberen Schwellwert auf einen unteren Wert zu bringen, der unter dem ersten vorbestimmten Grenzwert liegt, und/oder auf einen oberen Wert, der über dem ersten vorbestimmten Grenzwert liegt, sowie Mittel (3 bis 6) aufweist, um das Spannungspotential an der Klemme für den unteren Schwellwert auf einen oberen Wert zu bringen, der über dem zweiten vorbestimmten Grenzwert liegt und/oder auf einen niedrigen Wert, der unter dem zweiten vorbestimmten Grenzwert liegt.

2. Schaltung nach Anspruch 1 mit zwei Komparatoren (1, 2), von denen der eine (1) an einem ersten seiner Eingänge, der die Klemme für den oberen Schwellwert der Schaltung bildet, zur Überwachung des Spannungspegels ein höheres Spannungspotential empfängt, das von der zu überwachenden Spannung abgeleitet wird, und am anderen Eingang ein erstes Bezugspotential, während der andere Komparator (2) an einem ersten seiner Eingänge, der die Klemme für den unteren Schwellwert der Schaltung bildet, zur Überwachung des Spannungspegels ein niedrigeres Spannungspotential empfängt, das von der zu überwachenden Spannung abgeleitet wird, und am anderen Eingang ein zweites Bezugspotential, das denselben Wert wie das erste Bezugspotential haben kann, wobei ein erster Umschalter (3), um ein höheres Spannungspotential als das erste Bezugspotential an den einen oder anderen Eingang anzulegen, und ein zweiter Umschalter (5) vorgesehen sind, um an den anderen Eingang ein niedriges Potential unterhalb des zweiten Bezugspotentials anzulegen.
